# EUROPÄISCHE PATENTSCHRIFT

(11) **EP 2 033 269 B1**
(45) Veröffentlichungstag und Bekanntmachung des Hinweises auf die Patenterteilung: **11.09.2013**
(21) Anmeldenummer: 07821613.2
(22) Anmeldetag: 22.10.2007
(51) Int. Cl.: H01R 12/59, H05K 5/06, H05K 3/32

(54) **ELEKTRONIKGEHÄUSE MIT STANDARDINTERFACE**
ELECTRONIC HOUSING COMPRISING A STANDARD INTERFACE
BOÎTIER ÉLECTRONIQUE COMPRENANT UNE INTERFACE STANDARD

(30) Priorität: 07.11.2006 DE 102006052459
(43) Veröffentlichungstag der Anmeldung: 11.03.2009
(73) Patentinhaber: Continental Automotive GmbH, 30165 Hannover (DE)
(72) Erfinder: LOIBL, Josef, 93077 Bad Abbach (DE); SMIRRA, Karl, 83512 Wasserburg (DE)
(86) Internationale Anmeldenummer: PCT/EP2007/061249
(87) Internationale Veröffentlichungsnummer: WO 2008/055766

(56) Entgegenhaltungen:
- WO-A-00/49841
- WO-A-98/44593
- WO-A-2006/010652

## Beschreibung

Die Erfindung betrifft ein Elektronikgehäuse für ein elektronisches Steuergerät gemäß dem Oberbegriff des Patentanspruchs 1 sowie ein Verfahren zur Herstellung eines solchen Gehäuses, insbesondere für Getriebe- oder Motorsteuerungen in der Automobilindustrie.

Elektroniksteuergeräte weisen im Allgemeinen eine Vielzahl an elektronischen Komponenten auf, welche in Verbindung mit anderen Komponenten außerhalb des Steuergerätes stehen. Sie werden normalerweise in spezielle Gehäuse eingesetzt, um sie gegen Umwelteinflüsse oder mechanische Beanspruchungen zu schützen. Zudem erfüllen die Gehäuse eine wichtige Abschirmfunktion. Um eine verlässliche Verbindung zu außerhalb des Gehäuses liegenden Komponenten zu ermöglichen, ist eine elektrische Verbindung von der Gehäuseinnenseite zur Gehäuseaußenseite notwendig.

### Stand der Technik

Die DE 10 2004 033 559 A1 beschreibt eine solche Verbindung, die zwischen der Gehäuseinnen- und der Gehäuseaußenseite angeordnet ist und fest mit der Gehäusewand umspritzt oder umpresst ist. Dabei besitzt die Gehäusewand einen Hohlraum, in den zusätzliches Dichtmaterial eingebracht wird. Dieses Dichtmaterial umschließt die elektrische Verbindung und dichtet die Durchführung der elektrischen Verbindung durch die Gehäusewand ab. Zusätzlich wird mit dem Dichtmaterial eine Abdichtung der Gehäusewand mit dem Deckel und/oder dem Boden ermöglicht.

Der Nachteil dieser Anordnung liegt darin, dass die Gehäusebauteile speziell für jedes Steuergerät aufgrund der eingespritzten bzw. eingepressten elektrischen Verbindungen hergegestellt werden müssen. Zudem können bei dem Dichtmaterial im Laufe der Lebensdauer eines solchen Steuergeräts Ermüdungserscheinungen auftreten, insbesondere in einem stark aggressiven Umfeld wie bei Getriebe-Steuergeräten, die von chemisch stark angreifendem Getriebeöl umgeben sind und gleichzeitig hohen Temperaturen standhalten müssen.

Die DE 33 15 655 A1 beschreibt eine elektrische Verbindung mittels flexiblen Leiterplatten. Die flexiblen Leiterplatten werden an einer Verbindungsstelle zwischen dem Gehäuse und dem Deckel eingelegt und sind ebenfalls über Formdichtungen mit dem Gehäuse und dem Deckel abgedichtet. Diese flexiblen Leiterbahnen können von der Verbindungsstelle direkt an das elektrische Bauteil im Gehäuseinnern geführt werden. Dadurch ist die Anordnung der Komponenten relativ flexibel.

Darüber hinaus ist aus der DE 10 2004 036 683 A1 bzw. der WO 00/49841 je eine Anordnung zur elektrischen Verbindung von Steuerelektronik zu peripheren Komponenten wie beispielsweise Sensoren, Ventile oder Stecker mittels Ankontaktierung an flexible Leiterplattenteilstücke bzw. an eine flexible Leiterplatte bekannt, wobei bei der WO 00/49841 die Anschlussstifte der peripheren Komponenten direkt über eine elektrische Verbindungsstelle mit der flexiblen Leiterplatte verbunden sind.

Beispielhaft für eine gattungsgemäße Ankontaktierung wird auf die DE 10 2004 050 687 A1 verwiesen. Dort wird eine Möglichkeit zur direkten Kontaktierung eines Kabels oder eines Kabelbündels beschrieben, das an eine flexible Leiterplatte angreift.

Auch hier besteht jedoch jeweils der Nachteil, dass für jedes Steuergerät ein individuell angepasstes und auf die beteiligten Komponenten abgestimmtes Layout für das Gehäuse und die Geometrie der flexiblen Leiterplatten gefertigt werden muss. Ändern sich die Vorgaben für die Kontaktierung der peripheren Komponenten oder gar die Größe und die Geometrie des zentralen Elektroniksubstrates, muss zwangsläufig auch ein neues Layout für das Gehäuse und die flexiblen Leiterplatten gefunden und angefertigt werden. Dieser Zwang besteht unabhängig davon, ob die flexiblen Leiterplatten einstückig oder als Teilstücke ausgebildet sind.

### Aufgabenstellung

Aufgabe der Erfindung ist es daher, ein variables Konzept für eine Mehrzahl von Gehäusen für ein elektronisches Steuergerät mit mindestens einer als flexible Leiterplatte ausgebildeten elektronischen Verbindung zwischen dem Gehäuseinnenraum und dem Gehäuseaußenraum bereit zu stellen, welche eine einheitliche, einfache und flexible Verbindung zu außerhalb des Gehäuses liegenden Komponenten ermöglicht. Zudem soll die Abdichtung der Durchführung der elektrischen Verbindung vorzugsweise hermetisch dicht sein und hohen mechanischen und chemischen Beanspruchungen über die gesamte Lebensdauer des Steuergerätes standhalten, auch bei hohen Temperaturen. Dies wird erfindungsgemäß mit einer Vorrichtung entsprechend des Patentanspruchs 1 sowie mit einem Verfahren zur Herstellung einer solchen Vorrichtung gemäß des Anspruchs 8 erreicht.

Erfindungsgemäß wird vorgeschlagen, mindestens einen frei zugänglichen, offenen Bereich der Kupfer-Leiterbahnen der flexiblen Leiterplatte außerhalb des von dem Gehäusedeckel abgedeckten Bereichs auf der Oberseite des Elektronikbauteils vorzusehen, dessen Größe sich an der Breitenvorgabe der spezifischen Kontaktart orientiert. Der offene Bereich der Leiterbahn weist außerdem eine mehr als ausreichende Länge auf, um variabel auf die Kontaktierungserfordernisse der unterschiedlichen Peripherien eingehen zu können. Auf diese Weise ist es erstmals möglich, ein vereinheitlichtes Konzept für eine Mehrzahl von gattungsgemäßen Elektronikgehäusen bereitzustellen, das vor allem durch eine standardisierte Fertigung der flexiblen Leiterplatten wesentlich kostengünstiger auf veränderte Vorgaben bei der Geometrie der peripheren Komponenten oder der Elektroniksubstrate eingehen kann. Insbesondere kann auch eine Größenanpassung des gesamten Gehäuses erstmals auf kostengünstige und einfache Weise vorgenommen werden. Eine bisher notwendige komplette Neukonstruktion des Elektronikgehäuses wird somit überflüssig.

Bevorzugt werden zur Kontaktierung einer außerhalb des Gehäuses liegenden Komponente mehrere parallel verlaufende offene Bereiche mit entsprechender Breite und Länge der Kupfer-Leiterbahnen bereitgestellt.

In einer bevorzugten Ausgestaltung weist der offene, frei zugängliche Bereich der Kupfer-Leitungsbahn eine Breite von ca. 3 mm auf. Diese Dimensionierung orientiert sich erfindungsgemäß an der vorgesehenen Kontaktierung.

Als elektrische Verbindung kann eine an sich bekannte flexible Leiterplatte mit Leiterbahnen verwendet werden. Es können aber auch gleichermaßen ein oder mehrere flexible Teilleiterplatten nach der in der DE 10 2004 036 683 A1 beschriebenen Anordnung eingesetzt werden. Vorteilhaft an diesem Ausführungsbeispiel ist, einzelne flexible Teilleiterplatten so vorzubereiten, dass die Ankontaktierungen an die offenen Bereiche der Leiterbahnen für einzelne Komponententypen bereits in diesem frühen Stadium der Fertigung eines Einzelbestandteils berücksichtigt und vereinheitlicht werden kann. Zudem erfüllt diese Ausführungsvariante die weiteren vorteilhaften Vorgaben, die Gesamtfläche der flexiblen Leiterplatten an sich gering zu halten, insbesondere aus Kostengründen. Weiterhin erlaubt diese Ausführungsform der Erfindung eine optimale Entflechtung der Signal- und Strompfade.

Die flexible Leiterplatte kann beispielsweise aus einer unteren Polyimid-Basisfolie, darauf in einer Klebeschicht eingebettet angeordneten metallischen Leiterbahnen und einer oberen Polyimid-Deckfolie bestehen. Bevorzugt können auch mehrlagige flexible Leiterplatten, die definitionsgemäß mehrere durch Isolationsschichten getrennte Kupferleiterbahnschichten aufweisen, als elektrische Verbindung verwendet werden.

Alternativ kann die obere Polyimid-Deckfolie auch ganz oder teilweise weggelassen werden, solange der nicht durch die obere Polyimid-Deckfolie abgedeckte Bereich durch andere Bestandteile des erfindungsgemäßen Gehäuses, wie beispielsweise durch den Gehäusedeckel und/oder durch Kontaktierungsabdeckungen, vor äußeren Einflüssen geschützt ist. Es können auch weitere, bevorzugt kostengünstigere, Materialien sowohl für die Basisfolie als auch für die Klebeschicht verwendet werden. So können beispielsweise zur Kostenreduzierung solche Materialien vorgesehen werden, die in einem Spritz-, Lackier- oder Siebdruckverfahren auftragbar sind. Daneben ist es möglich, die Schichtdicke der einzelnen Schichten zu variieren.

Zur Ermöglichung der späteren Aufbringung des Gehäusedeckels kann beispielsweise eine umlaufende Vertiefung zur Aufnahme einer Dichtung oder eines Dichtungsmaterials vorgesehen werden. Alternativ oder kumulativ kann der Gehäusedeckel auch durch Nieten, Kleben oder Löten mit der Grundplatte und/oder der flexiblen Leiterplatte verbunden werden. Wichtig dabei ist vor allem, eine gute Abdichtung zu gewährleisten, sollen die Elektronikbauteile später in aggressiver Umgebung, wie zum Beispiel in einem Getriebe oder in einem Motor, eingesetzt werden.

Wird der Gehäusedeckel mittels Löten befestigt, so wird zunächst eine ununterbrochen umlaufende metallische Bahn auf der Oberfläche der Bodenplatte und/oder flexiblen Leiterbahn angeordnet. Vorzugsweise bildet dieser metallische Bereich die Aufsatzfläche des Gehäusedeckels ab.

Der Gehäuseboden besteht bevorzugter Weise aus einem metallischen Material, besonders bevorzugt ist er aus Aluminium. In einer bevorzugten Ausführungsform der Erfindung wird die flexible Leiterplatte auf den metallischen Gehäuseboden auflaminiert. Dies stellt eine verlässliche, dichte und kostengünstige Fixierung sicher. Der Gehäusedeckel kann aus jedem Material bestehen, das einen ausreichenden Schutz der Elektronik gegenüber den gegebenen Umwelteinflüssen sicherstellt. Neben Gehäusedeckeln aus Kunststoff können auch solche aus metallischen Materialien verwendet werden. Wenn eine Fixierung des Gehäusedeckels mittels Verlöten angestrebt wird, sollte vorzugsweise ein Gehäusedeckel aus Metall vorgesehen werden. Dieser bringt gleichzeitig die notwendigen EMV-Abschirmwerte und eine erhöhte Steifigkeit mit. Alternativ kann auch ein metallisierter Kunststoff-Formkörper eingesetzt werden. In einer vorteilhaften Ausgestaltung wird der Gehäusedeckel jedoch aus einem metallischen Material wie beispielsweise Stahlblech oder Druckguss gefertigt. Dadurch ergeben sich eine erhöhte Langzeitstabilität, eine gute Diffusionsdichte gegenüber aggressiven Chemikalien und verbesserte Abschirmwerte über die gesamte Lebensdauer des Steuergeräts.

Zur Herstellung eines erfindungsgemäßen Gehäuses für ein Steuergerät wird eine einstückige flexible Leiterplatte oder ein oder mehrere flexible Teilleiterplatten auf den Gehäuseboden aufgebracht, die mindestens einen erfindungsgemäßen offenen Bereich der Kupfer-Leiterbahn mit einheitlicher Breite und Länge aufweisen. Die Kontaktierungen zu den elektronischen Komponenten im Inneren des Gehäuses werden hergestellt und anschließend wird der Gehäusedeckel auf den entsprechenden Bereich der elektronischen Verbindung aufgebracht und fixiert. Die offenen Bereiche der flexiblen Leiterplatte mit den anschließend hergestellten Kontaktierung werden vorzugsweise durch Kontaktierungsabdeckungen vor äußeren Einflüssen geschützt. Solche äußeren Einflüsse können beispielsweise metallische Späne aus Fertigungsrückständen des Getriebe- oder Motorgehäuses beinhalten, die zu Kurzschlüssen der Kontaktierungen oder der offenen Bereiche der Kupfer-Leitungsbahnen führen könnten.

Gemäß der vorliegenden Erfindung werden eine flexible Leiterplatte oder mehrere flexible Teilleiterplatten auf einen Gehäuseboden, bevorzugt aus Aluminium, auflaminiert. Besonders bevorzugt wird die flexible Leiterplatte mittels Acrylkleber auf dem Gehäuseboden fixiert.

Verbindungen zwischen den außerhalb des Gehäuses angeordneten elektronischen Komponenten und der elektronischen Verbindung der vorliegenden Erfindung können auf jede bekannte Weise hergestellt werden. So können die Verbindungen lösbar beispielsweise als Stecker oder nicht lösbar durch beispielsweise Löten oder Schweißen hergestellt werden. Die elektronische Verbindung wird besonders bevorzugt direkt sowohl mit dem elektronischen Substrat im Inneren des Gehäuses als auch mit den Signalgebern und -empfängern (insbesondere Sensoren, Ventile, etc.) außerhalb des Gehäuses verbunden, und insbesondere bevorzugt mittels Dickdraht-Bonden. Die Anzahl der Verbindungen kann somit deutlich reduziert und auf diese Weise Teileausfälle aufgrund von schadhaften Schnittstellen wie beispielsweise Steckern vermieden werden. Die Fehleranfälligkeit vermindert sich dadurch erheblich.

Die Erfindung wird nachfolgend in beispielhafter Weise anhand von zwei Ausführungsvarianten in Verbindung mit den Zeichnungen erläutert.

In dieser zeigt:
**Fig. 1** eine teil-explodierte perspektivische Draufsicht eines Elektronikgerätes,
**Fig. 2** eine perspektivische Draufsicht auf das Elektronikgerät in Fig. 1 mit geschlossenem Gehäuse,
**Fig. 3** eine Schnittdarstellung eines Teilabschnitts einer flexiblen Leiterplatte,
**Fig. 4** eine Draufsicht in teil-explodierter Darstellung auf ein erfindungsgemäßes Elektronikgerät enthaltend eine einstückige flexible Leiterplatte ohne Decklage,
**Fig. 5** eine Schnittdarstellung eines Teilabschnitts einer Seite des Elektronikgerätes aus Fig. 4 mit einer geschlossenen Kontaktierabdeckung,
**Fig. 6** ein Elektronikgerät aus Fig. 4 mit geschlossenem Gehäuse und geschlossenen Kontaktierabdeckungen, und
**Fig. 7** zeigt eine weitere bevorzugte Ausgestaltung der Erfindung als teil-explodierte Darstellung mit flexiblen Teilleiterelementen.

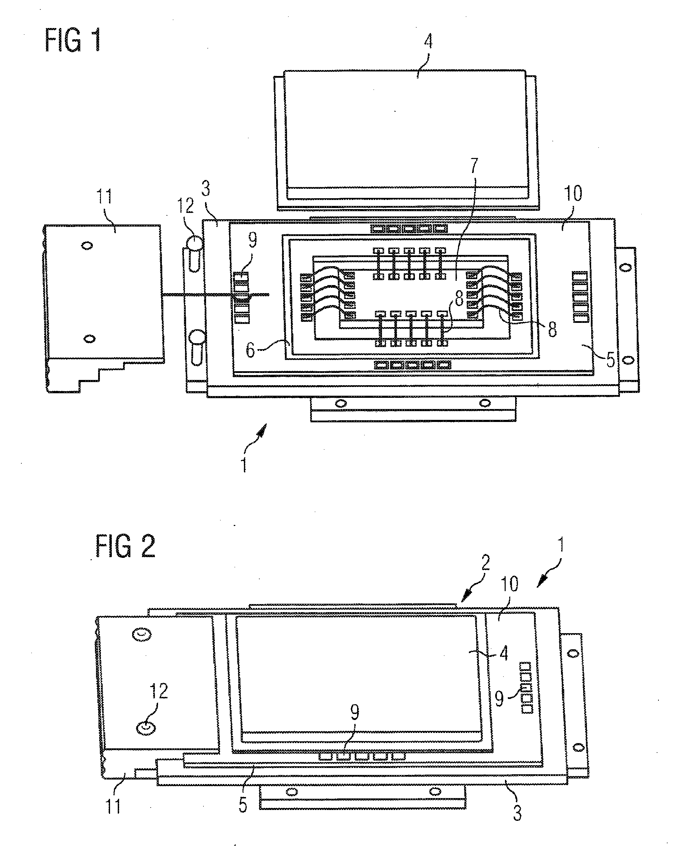

**Fig. 1** zeigt ein Elektronikgerät **1,** das zum Einbau in ein Kraftfahrzeuggetriebe vorgesehen ist. Das Gehäuse **2** des Elektronikgerätes wird von einer metallischen Bodenplatte **3** und einem Gehäusedeckel **4** aus Stahlblech oder Aluminium gebildet. Auf der metallischen Bodenplatte **3** ist eine flexible Leiterplatte **5** fixiert. Die Leiterplatte **5** weist umlaufend eine Abdichtzone **6** auf, die in ihrer Form der Aufsatzfläche des Gehäusedeckels **4** entspricht. Innerhalb des Gehäuses befindet sich ein Elektronik-Substrat **7,** das beispielsweise verschiedene elektronische Bauteile aufweisen kann. Das Substrat **7** mit seinen verschiedenen elektronischen Bauteilen im Innern des Gehäuses ist über Direktkontakte **8** mit der flexiblen Leiterplatte **5** verbunden. Weiterhin ist die gezeigte flexible Leiterplatte **5** im Innenbereich des Gehäuses ausgeschnitten und in dem so entstandenen Ausschnitt ist das elektronische Substrat **7** angeordnet. Die flexible Leiterplatte **5** weist in ihren Randbereichen Kontaktierungsstellen **9** zur direkten Kontaktierung mit peripheren Komponenten auf, die in ihrer Größe und Anordnung speziell angepasst sind an die zu verbindenden, außerhalb des Gehäuses liegenden Komponenten. Diese Kontaktierungsstellen **9** werden nicht von der schützenden oberen Decklage **10** der Leiterplatte **5,** sondern über separate Kontaktierabdeckungen **11** als Spanschutz und Schutz vor anderen Umwelteinflüssen bedeckt.

**Fig. 2** zeigt ein Elektronikgerät **1** aus Fig. 1 mit geschlossenem, dichtem Gehäuse **2**. Die Bodenplatte **3** trägt die Leiterplatte **5,** wobei der Gehäusedeckel **4** umlaufend fest direkt auf der Leiterplatte **5** angeordnet ist. Die Leiterplatte **5** hat eine größere Fläche als der Gehäusedeckel **4** und ragt unter der Aufsatzfläche des Deckels **4** hervor. Die Kontaktierungsstellen **9** sind außerhalb des Gehäusedeckels **4** im Randbereich der Leiterplatte angeordnet. An einer Seite der Leiterplatte **5** sind in der Darstellung die offenen Kontaktierungsstellen **9** mit einer Kontaktierabdeckung **11** abgedeckt. Die übrigen Leiterbahnbereiche sind durch die obere Decklage **10** der Leiterplatte **5** geschützt. Die Kontaktierabdeckungen **11** sind mit Befestigungsmitteln **12** an der Bodenplatte **3** des Elektronikgerätes **1** festgelegt.

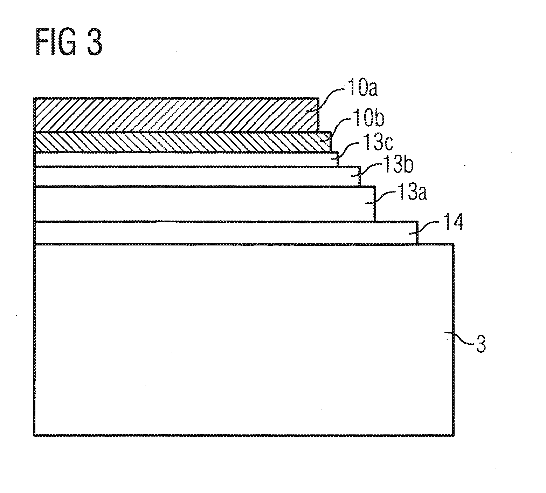

**Fig. 3** zeigt in einer Schnittdarstellung den Aufbau der verschiedenen Schichten einer flexiblen Leiterplatte **5** für den Verbindungsaufbau in mechatronischen Anwendungen.

Dieser besteht aus einer Basislage **13** als Verbund aus Polyimidfolie **13a,** Akrylkleberfolie **13b** und Cu-Folie **13c.** Die Kupferlage **13c** erhält durch einen Ätzprozess eine leitende Bahnstruktur. Zum notwendigen Schutz vor Kontamination, Beschädigungen und Leiterbahnkurzschlüssen (Spanschutz), wird eine Decklage **10** aus Polyimidfolie **10a** auf die strukturierte Cu-Lage **13c** mit Akrylkleber **10b** auflaminiert. Dieser gesamte Verbund aus Basislage **13** und Decklage **10** wird dann mittels einer weiteren Klebeschicht **14** auf eine Bodenplatte **3** auflaminiert.

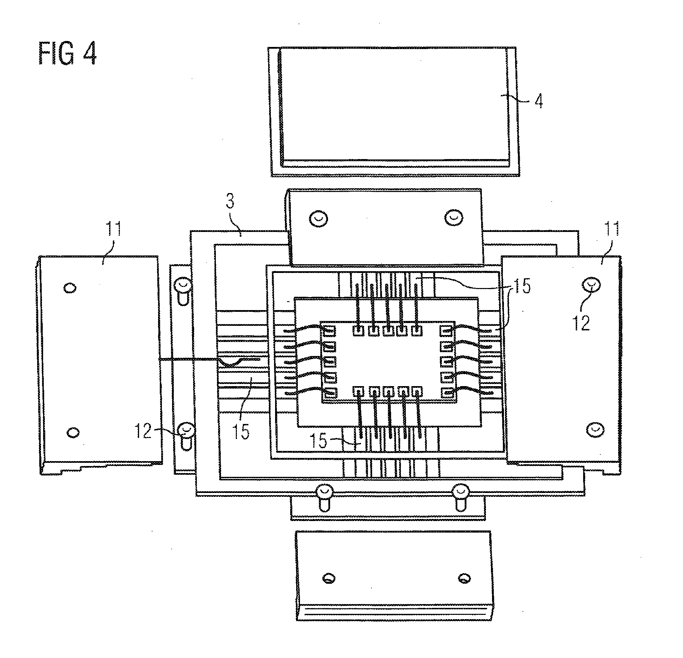

**Fig. 4** zeigt eine bevorzugte Ausgestaltung des erfindungsgemäßen Elektronikgerätes **1**. Das Gehäuse **2** des Elektronikgerätes **1** wird von einer metallischen Bodenplatte **3** und einem Gehäusedeckel **4** aus Stahlblech oder Aluminium gebildet. Auf der metallischen Bodenplatte **3** ist eine einstückige flexible Leiterplatte **5** fixiert. Diese Leiterplatte **5** ist ohne Decklage **10** gefertigt und sämtliche Leiterbahnbereiche **15** liegen daher offen. Die flexible Leiterplatte **5** weist umlaufend eine Abdichtzone **6** auf, die in ihrer Form im Wesentlichen der Aufsatzfläche des Gehäusedeckels **4** entspricht. Innerhalb des Gehäuses befindet sich ein Elektronik-Substrat **7**, das beispielsweise mehrere verschiedene elektronische Bauteile umfasst. Weiterhin ist die gezeigte flexible Leiterplatte **5** im Innenbereich des Gehäuses ausgeschnitten und in dem so entstandenen Ausschnitt ist das elektronische Substrat **7** angeordnet. Die Verbindungen von dem elektronischen Substrat **7** zur flexiblen Leiterplatte **5** werden mittels Dickdraht-Bonden **8** hergestellt. Das elektronische Substrat **7** beinhaltet bevorzugt mehrere einzelne Bauteile und ist besonders bevorzugt ein Keramik-Substrat. Die erfindungsgemäßen offenen Leiterbahnbereiche mit einer Breite, die sich an den Kontaktierungstyp für die jeweiligen nicht dargestellten peripheren Komponenten orientiert und deren Länge größer ist als für die Kontaktierung notwendig, werden innerhalb der Abdichtzone **6** des Gehäusedeckels **4** vor Kontaminierungen und Umwelteinflüssen und außerhalb über die separaten Kontaktierabdeckungen **11** geschützt. Zwei der Kontaktierabdeckungen **11** sind befestigt und teilweise überlappend mit der Abdichtzone **6** dargestellt. Die Kontaktierabdeckungen **11** können alternativ teilweise überlappend oder aber auch bündig mit dem Gehäusedeckel **4** abschließen, so dass ein Spanschutz und Schutz vor weiterer Kontaminierung der offenen Leiterbahnbereiche **15** gewährleistet ist.

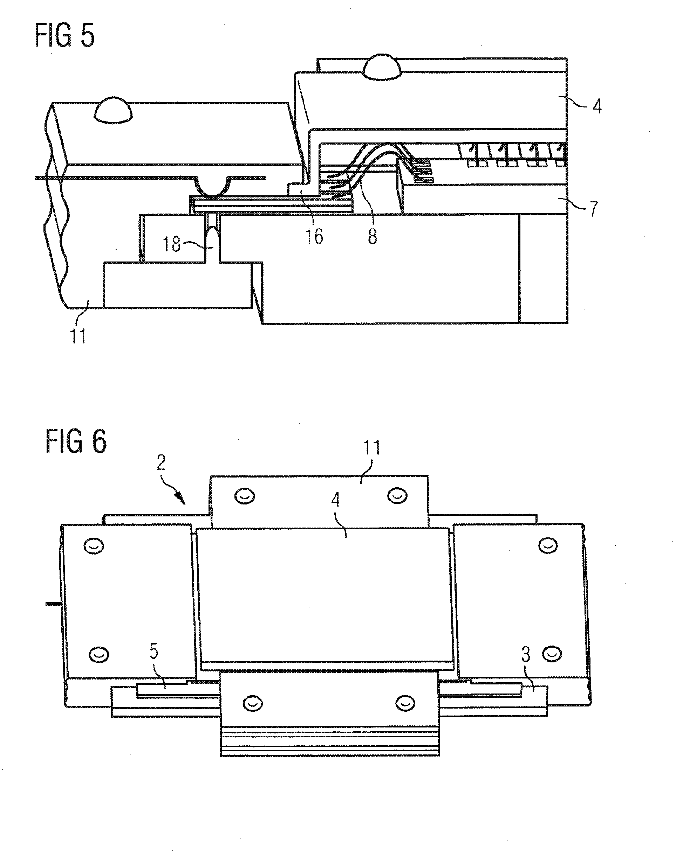

**Fig. 5** zeigt eine Schnittdarstellung einer Seite des Elektronikgeräts **1** aus Fig. 4 mit einem geschlossenen Gehäuse **1** und einer geschlossenen Kontaktierabdeckung **11.** Die Kontaktierabdeckung **11** und Gehäusedeckel **4** sind derart ausgebildet und überlappend angeordnet, dass ein Labyrinth Dichtungspfad **16** zur Abdeckung der erfindungsgemäß einheitlichen, offenen Leiterbahnbereiche **15** der flexiblen Leiterplatte **5** gebildet wird. Gemäß der vorliegenden bevorzugten Ausgestaltung der Erfindung weist der Gehäuseboden **3** im Bereich der Kontaktierungsstelle für die außerhalb liegenden Komponenten eine Aussparung **18** auf, die hier durch eine in die Aussparung **18** hineinragende Abdeckung verschlossen ist.

**Fig. 6** zeigt das Elektronikgerät **1** aus Fig. 4 und Fig. 5 mit geschlossenem, hermetisch dichtem Gehäuse **2** und befestigten Kontaktierabdeckungen **11.** Die erfindungsgemäßen einheitlichen, offenen Leiterbahnbereiche **15** sind hierdurch vollständig abgedeckt.

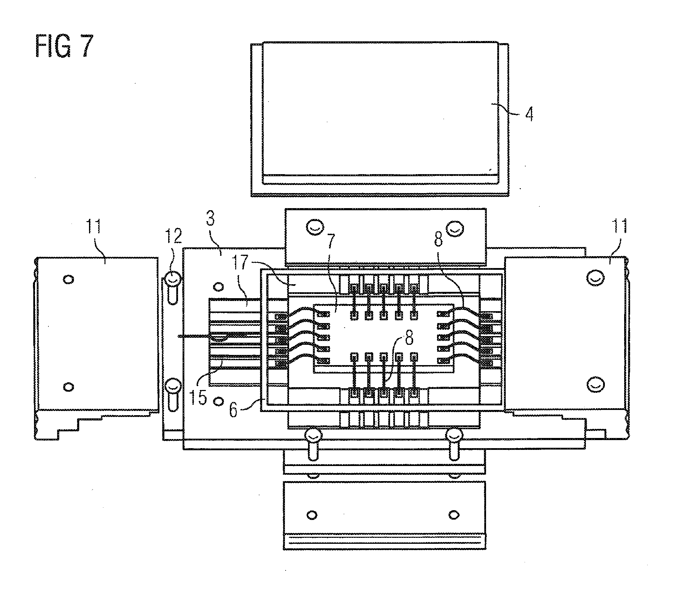

**Fig. 7** zeigt eine weitere bevorzugte Ausgestaltung des erfindungsgemäßen Elektronikgerätes **1**. Der Aufbau entspricht im Wesentlichen der in Fig. 4. In dieser Ausführungsform ist jedoch die flexible Leiterplatte **5** nicht einstückig ausgeführt, sondern die Kontaktierung zu den peripheren Komponenten wird durch einzelne flexible Teilleiterfolienelemente **17** mit erfindungsgemäß einheitlichen, offenen Leiterbahnen **15** hergestellt.

Dies ermöglicht eine optimale Entflechtung von Signal- und Strompfaden und der Einsatz teuerer flexibler Leiterplattenflächen kann auf ein Minimum reduziert werden. Die flexiblen Teilleiterplatten können somit so ausgestaltet sein, dass eine optimale Nutzenauslastung möglich ist und nur geringer Verwurf entsteht.

Zusammenfassend wird demnach ein Konzept zur Bereitstellung eines Gehäuse mit einem Gehäuseboden und einem Gehäusedeckel sowie einer elektronischen Verbindung zwischen dem Innenraum des Gehäuses und den außerhalb des Gehäuses liegenden Komponenten vorgeschlagen, bei dem die flexible Leiterplatte standardisierte offene Bereiche der Kupferleiterplatte für die Kontaktierung der peripheren Komponenten aufweist. Die Breite der standardisierten offenen Bereiche orientiert sich an dem vorgegebenen Typ der Kontaktierung und deren Länge ist größer als für die unmittelbare Kontaktierung notwendig. Auf diese Weise ist erstmals eine variable Anpassung von Elektronikgehäusen an sich ändernde Vorgaben bezüglich der äußeren Komponenten oder des Elektroniksubstrats möglich. Insbesondere kann auch eine Größenanpassung des gesamten Gehäuses erstmals auf kostengünstige und einfache Weise vorgenommen werden. Eine aufwendige Neukonzeption des Elektronikgerätes kann hierdurch vermieden werden. Zusätzlich ist eine vereinheitlichte Fertigung der flexiblen Leiterplatten möglich, was zu einem erheblichen Kostenvorteil führen kann.

Durch einen standardisierten Aufbau kann weiterhin eine erleichterte Qualitätskontrolle und damit eine erhebliche Fehlerreduktion solcher Bauteile aufgrund von schadhaften Schnittstelen erzielt werden. Erfindungsgemäße Elektronikgeräte können vorteilhafter Weise in einem Temperaturbereich von -40 °C bis +180 °C verwendet werden.

## Patentansprüche

1. Gehäuse (2) für eine elektronische Vorrichtung mit mindestens zwei Gehäuseteilen, welches mindestens einen Gehäuseboden (3), einen Gehäusedeckel (4) und mindestens eine elektronische Verbindung (5) in Form einer flexiblen Leiterplatte zwischen im Gehäuseinnenraum angeordneten Bauteilen (7) und außerhalb des Gehäuses liegenden Komponenten aufweist, die auf dem Gehäuseboden (3) fixiert ist, wobei die elektronische Verbindung (5) mindestens einen einheitlichen, offenen, frei zugänglichen Bereich der Kupfer-Leiterbahn (9)zum unmittelbaren Kontaktieren mit außerhalb des Gehäuses (2) liegenden Komponenten aufweist, dessen Breite sich durch die Kontaktierungsart für die außerhalb des Gehäuses liegenden Komponenten bestimmt und dessen Länge größer ist als die Kontaktierungsart erfordert, um variabel auf die Kontaktierungserfordernisse der unterschiedlichen Peripherien eingehen zu können, und wobei der Gehäuseboden (3) eine größere Grundfläche aufweist als der Gehäusedeckel (4).

2. Gehäuse (2) nach Anspruch 1, **dadurch gekennzeichnet, dass** mehrere parallel verlaufende offene Bereiche (9) mit der Kontaktierungsart entsprechender Breite der Kupfer-Leiterbahnen bereitgestellt werden.

3. Gehäuse (2) nach Anspruch 1 oder 2, **dadurch gekennzeichnet, dass** die elektronische Verbindung (5) eine mehrlagige flexible Leiterplatte ist.

4. Gehäuse (2) nach einem der vorhergehenden Ansprüche, **dadurch gekennzeichnet, dass** die flexible Leiterplatte (5) über den Gehäuseboden (3) hinausragt.

5. Gehäuse (2) nach einem der vorhergehenden Ansprüche, **dadurch gekennzeichnet, dass** die elektronische Verbindung (5) aus mindestens zwei oder mehreren flexiblen Teilleiterplatten (17) gebildet wird.

6. Gehäuse (2) nach einem der vorhergehenden Ansprüche, **dadurch gekennzeichnet, dass** die außerhalb des Gehäuses liegenden Komponenten direkt an die elektronische Verbindung (5) geschweißt oder gelötet sind.

7. Verfahren zur Herstellung eines Gehäuses (2) mit den Merkmalen mindestens eines der vorhergehenden Ansprüche, **dadurch gekennzeichnet, dass** mindestens eine elektronische Verbindung (5) auf den Gehäuseboden (3) aufgebracht wird, mit dem elektronischen Substrat im Innern des Gehäuses (7) und den außerhalb des Gehäuses liegenden Komponenten verbunden wird und der Gehäusedeckel (4) auf die Abdichtzone (6) befestigt wird.

8. Verfahren nach Anspruch 7, **dadurch gekennzeichnet, dass** die Verbindung des elektronischen Substrats (7) mit der elektronischen Verbindung (5) mittels Dickdraht-Bonden und die Verbindung der peripheren Komponenten mit der elektronischen Verbindung (5) mittels Löten, Schweißen oder Crimpen durchgeführt wird.

9. Verfahren nach einem der Ansprüche 7 oder 8, **dadurch gekennzeichnet, dass** mindestens eine flexible Leiterplatte als elektronische Verbindung (5) auf den Gehäuseboden (3) auflaminiert wird.

10. Verwendung eines Gehäuses (2) für ein elektronisches Steuergerät, bevorzugt für eine Getriebesteuerung eines Kraftfahrzeugs, **gekennzeichnet durch** eine elektronische Verbindung (5) mit mindestens einem einheitlichen, offenen, frei zugänglichen Bereich der Kupfer-Leitungsbahn (9) nach einem der vorhergehenden Ansprüche.

## Claims

1. A housing (2) for an electronic device having at least two housing parts, which has at least one housing bottom (3), one housing lid (4) and at least one electronic connection (5) in the form of a flexible printed circuit board between components (7) arranged in the internal space of the housing and components located outside the housing, which is fixed on the housing bottom (3), wherein the electronic connection (5) has at least one unitary, open, freely accessible area of the copper conductor path (9) for direct bonding with components located outside the housing (2), the width of which is determined by the type of bonding for the components located outside of the housing and the length of which is greater than required by the type of bonding to be able to variably respond to the bonding requirements of the different peripheries, and wherein the housing bottom (3) has a greater surface area than the housing lid (4).

2. The housing (2) according to claim 1, **characterized in that** a plurality of parallel open areas (9) of the copper conductor path having a width corresponding to the type of bonding are provided.

3. The housing (2) according to claim 1 or 2, **characterized in that** the electronic connection (5) is a multilayer flexible printed circuit board

4. The housing (2) according to any one of the preceding claims, **characterized in that** the flexible printed circuit board (5) protrudes beyond the housing bottom (3).

5. The housing (2) according to any one of the preceding claims, **characterized in that** the electronic connection (5) is formed from at least two or more flexible partial printed circuit boards (17).

6. The housing (2) according to any one of the preceding claims, **characterized in that** the components located outside the housing are directly welded or soldered to the electronic connection (5).

7. A method for producing a housing (2) having the features of at least one of the preceding claims, **characterized in that** at least one electronic connection (5) is applied to the housing bottom (3), is connected to the electronic substrate inside the housing (7) and the components located outside of the housing, and the housing lid (4) is fastened to the sealing zone (6).

8. The method according to claim 7, **characterized in that** the connection of the electronic substrate (7) to the electronic connection (5) is performed by means of heavy wire bonding and the connection of the peripheral components to the electronic connection is performed (5) by means of soldering, welding or crimping.

9. The method according to any one of claims 7 or 8, **characterized in that** at least one flexible printed circuit board is laminated on the housing bottom (3) as an electronic connection (5).

10. Use of a housing (2) for an electronic control unit, preferably a transmission control of a motor vehicle, **characterized by** an electronic connection (5) having at least one unitary, open, freely accessible area of the copper conductor path (9) according to any one of the preceding claims.

## Revendications

1. Boîtier (2) pour un dispositif électronique avec au moins deux parties de boîtier, qui présente au moins un fond de boîtier (3), un couvercle de boîtier (4) et au moins une connexion électronique (5) sous forme de carte de circuit imprimé flexible entre des éléments constitutifs (7) disposés dans l'espace intérieur du boîtier et des composants situés à l'extérieur du boîtier, qui est fixée sur le fond de boîtier (3), la connexion électronique (5) présentant au moins une zone uniforme, ouverte, librement accessible de la piste conductrice en cuivre (9) pour la mise en contact directe avec des composants situés à l'extérieur du boîtier (2), zone dont la largeur est déterminée par le type de mise en contact pour les composants situés à l'extérieur du boîtier et dont la longueur est plus grande que l'exige le type de mise en contact pour pouvoir répondre de façon variable aux besoins de mise en contact des différentes périphéries, et le fond de boîtier (3) présentant une surface de base plus grande que le couvercle de boîtier (4).

2. Boîtier (2) selon la revendication 1, **caractérisé en ce que** plusieurs zones (9) ouvertes placées en parallèle avec le type de mise en contact de largeur correspondante des pistes conductrice en cuivre (9) sont fournies.

3. Boîtier (2) selon la revendication 1 ou 2, **caractérisé en ce que** la connexion électronique (5) est une carte de circuit imprimé flexible à plusieurs couches.

4. Boîtier (2) selon une des revendications précédentes, **caractérisé en ce que** la carte de circuit imprimé (5) flexible dépasse du fond de boîtier (3).

5. Boîtier (2) selon une des revendications précédentes, **caractérisé en ce que** la connexion électronique (5) est formée d'au moins deux cartes de circuit imprimé partielles (17) flexibles ou davantage.

6. Boîtier (2) selon une des revendications précédentes, **caractérisé en ce que** les composants situés à l'extérieur du boîtier sont soudés ou brasés directement sur la connexion électronique (5).

7. Procédé de fabrication d'un boîtier (2) ayant les caractéristiques d'au moins une des revendications précédentes, **caractérisé en ce qu'**au moins une connexion électronique (5) est mise en place sur le fond de boîtier (3), est connectée au substrat électronique dans l'intérieur du boîtier (7) et aux composants situés à l'extérieur du boîtier, et **en ce que** le couvercle de boîtier (4) est fixé sur la zone d'étanchéité (6).

8. Procédé selon la revendication 7, **caractérisé en ce que** la connexion du substrat électronique (7) à la connexion électronique (5) est effectuée au moyen du bonding à fil épais et **en ce que** la connexion des composants périphériques à la connexion électronique (5) est réalisée par brasage, soudage ou sertissage.

9. Procédé selon une des revendications 7 ou 8, **caractérisé en ce qu'**au moins une carte de circuit imprimé flexible est laminée en tant que connexion électronique (5) sur le fond de boîtier (3).

10. Utilisation d'un boîtier (2) pour un appareil de commande électronique, de préférence pour une commande de boîte de vitesses d'un véhicule automobile, **caractérisée par** une connexion électronique (5) avec au moins une zone uniforme, ouverte, librement accessible de la piste conductrice en cuivre (9) selon une des revendications précédentes.
